# EUROPÄISCHE PATENTSCHRIFT

(11) **EP 2 195 668 B1**
(45) Veröffentlichungstag und Bekanntmachung des Hinweises auf die Patenterteilung: **12.01.2011**
(21) Anmeldenummer: 08802775.0
(22) Anmeldetag: 02.10.2008
(51) Int. Cl.: G01R 31/28

(54) **PLUNGER ZUM HALTEN UND BEWEGEN ELEKTRONISCHER BAUELEMENTE, INSBESONDERE IC'S**
PLUNGER FOR HOLDING AND MOVING ELECTRICAL COMPONENTS IN PARTICULAR IC'S
PLONGEUR POUR MAINTENIR ET DÉPLACER DES COMPOSANTS ÉLECTRONIQUES, NOTAMMENT DES CIRCUITS INTÉGRÉS

(30) Priorität: 05.10.2007 DE 102007047740
(43) Veröffentlichungstag der Anmeldung: 16.06.2010
(73) Patentinhaber: Multitest elektronische Systeme GmbH, 83026 Rosenheim (DE)
(72) Erfinder: SCHAULE, Max, 87719 Mindelheim (DE); THIEL, Stefan, 83022 Rosenheim (DE); WIESBÖCK, Andreas, 83071 Stephanskirchen (DE); JESERER, Günther, 83104 Tuntenhausen (DE); BAUER, Alexander, 83026 Rosenheim (DE); PICHL, Franz, 83236 Übersee (DE)
(74) Vertreter: Bauer, Friedrich
(86) Internationale Anmeldenummer: PCT/EP2008/008389
(87) Internationale Veröffentlichungsnummer: WO 2009/046945

(56) Entgegenhaltungen:
- WO-A-97/15837
- US-A- 5 977 785
- US-A1- 2006 261 833

## Beschreibung

Die Erfindung betrifft einen Plunger zum Halten und Bewegen von elektronischen Bauelementen, insbesondere zum Zuführen und Wegbewegen von IC's zu bzw. von einer mit einer Testvorrichtung verbundenen Kontakteinrichtung, gemäß dem Oberbegriff des Anspruchs 1.

Elektronische Bauelemente, wie beispielsweise IC's (Halbleiterbauelemente mit integrierten Schaltungen), werden üblicherweise auf ihre Funktionsfähigkeit hin überprüft, bevor sie beispielsweise auf Leiterplatten montiert oder anderweitig verwendet werden. Die zu testenden Bauelemente werden hierbei von einem üblicherweise als "Handler" bezeichneten Handhabungsautomaten mit Kontakteinrichtungen kontaktiert, die insbesondere als Kontaktsockeln ausgebildet sind und mit einem Testkopf einer Testvorrichtung in elektrischem Kontakt stehen. Nach Beendigung des Testvorgangs werden die Bauelemente mittels des Handlers wieder von den Kontakteinrichtungen entfernt und in Abhängigkeit des Testergebnisses sortiert.

Zum Halten und Kontaktieren der Bauelemente weisen Handler üblicherweise Plunger auf, d.h. längsverschiebbare Halteeinheiten, welche die Bauelemente insbesondere durch Aufbringen einer Saugkraft mittels Vakuum halten können. Die Plunger werden nach dem Aufsetzen der Bauelemente innerhalb des Handlers in eine Position gebracht, in der sie auf geradlinigem Weg weiter zu Kontakteinrichtungen vorgeschoben werden können, bis die Bauelemente mit den Kontakteinrichtungen in Kontakt gelangen. Nach Durchführung der Testvorgänge werden die Bauelemente mittels der Plunger wieder vom Testkopf entfernt und derart positioniert, dass sie über eine Entladestation aus dem Handler entfernt und in Abhängigkeit des Testergebnisses sortiert werden können.

Um die Tests unter bestimmten Temperaturbedingungen durchführen zu können, ist es weiterhin bekannt, die Bauelemente vor dem Testvorgang auf bestimmte Temperaturen zu temperieren. Diese Temperaturen können beispielsweise in einem Bereich von -60°C bis +200°C liegen.

Die Temperierung der Bauelemente erfolgt üblicherweise auf konvektive und/oder konduktive Weise in einer wärmeisolierten Temperierkammer, die innerhalb oder außerhalb des Handlers angeordnet sein kann. Hierbei wird eine Vielzahl von Bauelementen gleichzeitig innerhalb der Temperierkammer auf die gewünschte Temperatur gebracht, bevor sie auf die Plunger aufgesetzt und von diesen zu den Kontakteinrichtungen vorgeschoben werden. Nachteilig ist hierbei, dass in der Zeit zwischen der Erwärmung und der Kontaktierung der Bauelemente Wärmeverluste auftreten, die dazu führen, dass die Bauelemente zum Testzeitpunkt nicht mehr genau die Soll-Temperatur haben. Auch kann es infolge des Kontakts mit den Kontakteinrichtungen während des Tests zu Wärmeströmungen zum Bauelement hin oder weg kommen. Weiterhin können auch die einzelnen Bauelemente, die zusammen in der Temperierkammer temperiert worden sind, unterschiedliche Temperaturen haben.

Aus der US 5,977,785 A ist ein Plunger gemäß dem Oberbegriff des Anspruchs 1 bekannt. Der dortige Plunger weist ein Kopfteil mit mehreren Saugköpfen und einer getrennt von den Saugköpfen angeordneten Kontaktplatte auf, die mittels eines warmen oder kalten Fluids erwärmt oder gekühlt werden kann. Die angesaugten Bauelemente liegen an der Kontaktplatte an und können über diese temperiert werden. Das temperierte Fluid wird in geschlossenen Kreisläufen der Kontaktplatte zugeführt und von dieser wieder abgeführt. Nachteilig ist hierbei jedoch, dass das Kopfteil komplex aufgebaut und eine relativ großformatige Kontaktplatte erforderlich ist, die über innenliegende Fluidkanäle und entsprechende Anschlüsse für die Fluidanschlussleitungen verfügt. Für sehr kleine Bauelemente ist ein derartiges Kopfteil nicht geeignet.

Der Erfindung liegt die Aufgabe zugrunde, einen Plunger der eingangs genannten Art zu schaffen, mit dem Tests von elektronischen Bauelementen unter bestimmten Temperaturbedingungen auf möglichst genaue Art und Weise durchgeführt werden können. Weiterhin soll der Plunger einfach aufgebaut sein und eine geringe Baugröße im Kopfbereich haben, so dass er auch für kleine Bauelemente geeignet ist.

Diese Aufgabe wird erfindungsgemäß durch einen Plunger mit den Merkmalen des Anspruchs 1 gelöst. Vorteilhafte Ausführungsformen der Erfindung sind in den weiteren Ansprüchen beschrieben.

Erfindungsgemäß weist das Kopfteil eine von temperiertem Fluid durchströmte Fluidverteilkammer auf, in welcher der Saugkopf angeordnet ist, so dass das temperierte Fluid den Saugkopf umströmt und längs des Saugkopfs zum Bauelement weitergeleitet wird.

Dadurch, dass die Temperiereinrichtung direkt am Plunger angeordnet ist, kann das am Plunger gehaltene Bauelement während seiner Zustellung zur zugeordneten Kontakteinrichtung und sogar noch während des Testvorgangs temperiert werden, so dass Wärmeverluste während der Zustellbewegung und während des Testvorgangs entfallen oder zumindest minimiert werden können. Die permanente Temperierung der Bauelemente ist damit während des gesamten Vorgangs auf sehr genaue Weise möglich. Die Fluidverteilkammer bewirkt hierbei auf besonders vorteilhafte Weise, dass das temperierte Fluid nicht nur punktuell, sondern großflächig auf das Bauelement auftrifft und dieses gleichmäßig erwärmt. Darüber hinaus kann das Kopfteil einfach aufgebaut sein und eine geringe Baugröße haben, so dass der Plunger nicht nur für großformatige, sondern auch für sehr kleine Bauelemente eingesetzt werden kann.

Als Fluid wird zweckmäßigerweise gereinigte Luft verwendet, die in entsprechender Weise temperiert wird. Alternativ ist es jedoch auch ohne weiteres möglich, andere Gase zu verwenden, was insbesondere bei Tieftemperaturtests vorteilhaft sein kann.

Gemäß einer vorteilhaften Ausführungsform umfasst die Fluidzuführleitung ein sich zwischen dem hinteren Endabschnitt und dem vorderen Plungerabschnitt erstreckendes Heizrohr, in dem eine Heizeinrichtung zum Erwärmen des Fluids vorgesehen ist. Die Heizeinrichtung kann dabei zweckmäßigerweise aus einer elektrischen Widerstandsheizung in Form einer Heizspirale bestehen, die sich zumindest über einen größeren Teil der Länge des Zwischenabschnittes erstreckt. Hierdurch kann das durch das Heizrohr hindurch strömende Fluid auf sehr effektive und genau regelbare Weise temperiert werden. Es sind jedoch jegliche andere Heizelemente, die sich von der Größe her implementieren lassen, vorstellbar.

Gemäß einer vorteilhaften Ausführungsform umfasst der vordere Abschnitt des Plungers einen am Zwischenabschnitt befestigten Basiskörper und das Kopfteil, das am Basiskörper festgelegt ist und eine die Fluidverteilkammer umfassende axiale Durchgangsöffnung aufweist, durch die das temperierte Fluid zum Bauelement geleitet wird. Durch die Aufteilung des vorderen Abschnitts des Plungers in einen Basiskörper und in ein Kopfteil ist eine relativ einfache Herstellung und Montage des vorderen Plungerabschnitts möglich.

Gemäß einer vorteilhaften Ausführungsform ist das Kopfteil seitlich verschiebbar am Basiskörper festgelegt und wird mittels Federelementen in eine zentrierte Stellung relativ zum Basiskörper gedrängt. Hierdurch ist es auf besonders einfache Weise möglich, das Bauelement beim Zuführen zur Kontakteinrichtung mittels einer unmittelbar vor der Kontakteinrichtung angeordneten Zentriereinrichtung relativ zur Kontakteinrichtung zu zentrieren, ohne dass der gesamte Plunger seitlich ausgelenkt werden muss. Vielmehr wird von der Zentriereinrichtung lediglich das Kopfteil seitlich relativ zum Basiskörper verschoben, falls dies erforderlich ist.

Gemäß einer vorteilhaften Ausführungsform ist die Fluidverteilkammer im Kopfteil angeordnet. Alternativ hierzu ist es jedoch auch denkbar, die Fluidverteilkammer im Basiskörper anzuordnen.

Gemäß einer vorteilhaften Ausführungsform ist in einem vorderen Endbereich der axialen Durchgangsöffnung ein aus einem gut wärmeleitfähigen Material bestehender Wärmeleitkörper angeordnet, der eine große, vom temperierten Fluid angeströmte Oberfläche aufweist und derart angeordnet ist, dass das vom Saugkopf festgesaugte Bauelement in großflächigem Kontakt mit dem Wärmeleitkörper ist. Hierdurch kann der Wärmeübergang vom temperierten Fluid zum Bauelement verbessert werden.

Vorteilhafterweise ist der Wärmeleitkörper federnd innerhalb der Durchgangsöffnung gehaltert, so dass die Lage des Wärmeleitkörpers an unterschiedliche Lagen des Bauelements anpassbar ist. Auf diese Weise ist sichergestellt, dass auch dann ein großflächiger und inniger Kontakt zwischen Wärmeleitkörper und Bauelement zustande kommt, wenn das Bauelement beim Ansaugen durch den Saugkopf etwas schräg auf die entsprechende Kontaktfläche des Wärmeleitkörpers auftrifft. Weiterhin liegen in diesem Fall die Anschlussbeinchen des Bauelements gleichmäßig auf Stützleisten (Leadbacker) auf, die vom Kopfteil nach vorne abstehen und die Bauelementbeinchen unterstützen. Das Bauelement wird somit durch den federnd angeordneten Wärmeleitkörper auch mechanisch geringer beansprucht.

Gemäß einer vorteilhaften Ausführungsform ist im vorderen Endbereich der Fluidzuführleitung ein Temperatursensor angeordnet, der Teil einer Regelvorrichtung zum Regeln der von der Temperiereinrichtung erzeugten Temperatur ist. Dadurch, dass sich der Temperatursensor sehr nahe am Bauelement befindet, kann sehr genau diejenige Temperatur erfasst werden, die im Bereich des Bauelements herrscht. Die Temperaturregelung kann daher auf sehr schnelle und genaue Weise erfolgen. Umfasst die Temperiereinrichtung eine am oder im Plunger angeordnete Heizeinrichtung zum Erwärmen von Fluid, das in der Fluidzuführleitung zum Bauelement geleitet wird, befindet sich der Temperatursensor somit zweckmäßigerweise zwischen dem Bauelement und der Heizeinrichtung, d.h., in Strömungsrichtung des Fluids gesehen, hinter der Heizeinrichtung und kurz vor dem zu testenden Bauelement. Mit Hilfe des Temperatursensors kann somit eine Regelschleife zur Anpassung der im Bereich des Bauelements vorhandenen Ist-Temperatur an die Soll-Temperatur verwirklicht werden.

Die Erfindung wird nachfolgend anhand der Zeichnungen beispielhaft näher erläutert. Es zeigen:
- Figur 1 :: eine perspektivische Darstellung eines erfindungsgemäßen Plungers, wobei das Kopfteil seines vorderen Abschnitts ge- trennt vom Basiskörper dargestellt ist,
- Figur 2 :: einen mittigen Längsschnitt durch den Plunger von Figur 1, wobei sich der Plun- ger in der zurückgezogenen Ausgangsstel- lung befindet,
- Figur 3 :: einen Längsschnitt gemäß Figur 2, wobei sich der Plunger in der vorgeschobenen Kontaktierstellung befindet,
- Figur 4 :: eine Explosionsdarstellung des Kopfteils im Längsschnitt sowie des Saugkopfs mit angrenzenden Teilen,
- Figur 5 :: eine Explosionsdarstellung mit weiteren Einzelteilen des Plungers, wobei die Teile von Figur 4 im zusammengebauten Zustand dargestellt sind,
- Figur 6 :: einen Längsschnitt durch die Teile von Figur 5 im zusammengebauten Zustand, wobei zusätzliche Federelemente zur Zentrierung des Kopfteils dargestellt sind,
- Figur 7 :: eine Draufsicht auf die Federelemente von Figur 6,
- Figur 8 :: eine Vorderansicht auf den Plunger,
- Figur 9 :: einen Längsschnitt eines Kopfteils des Plungers, in dem ein Wärmeleitkörper ein- gesetzt ist,
- Figur 10 :: eine Draufsicht auf den Wärmeleitkörper von Figur 9, und
- Figur 11 :: eine Draufsicht auf ein Bauelement.

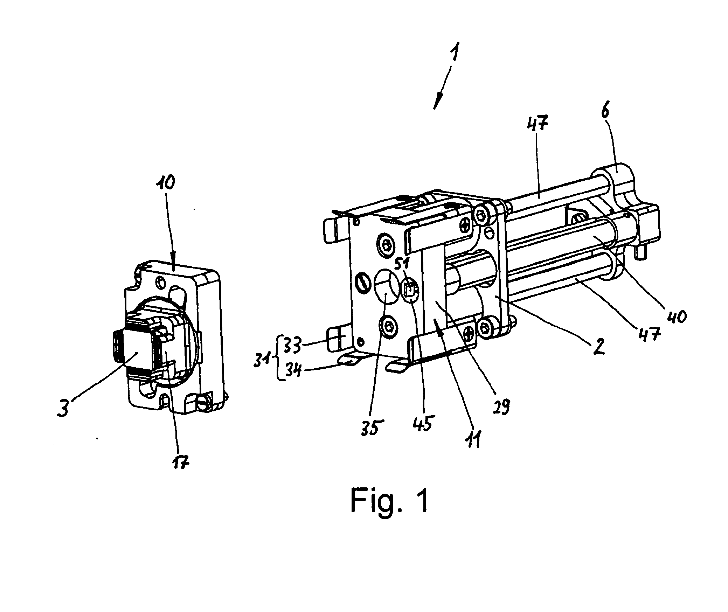

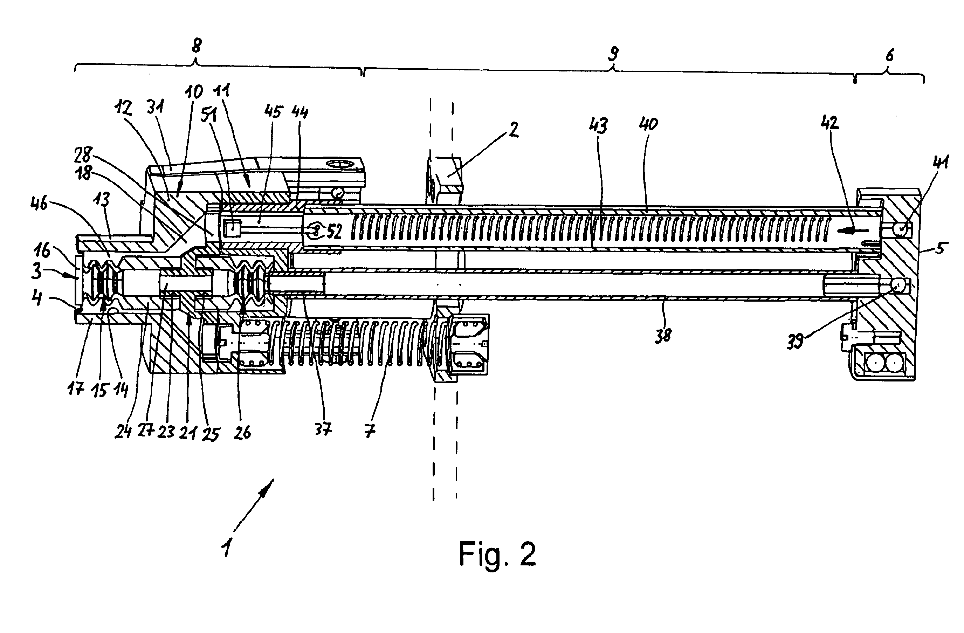

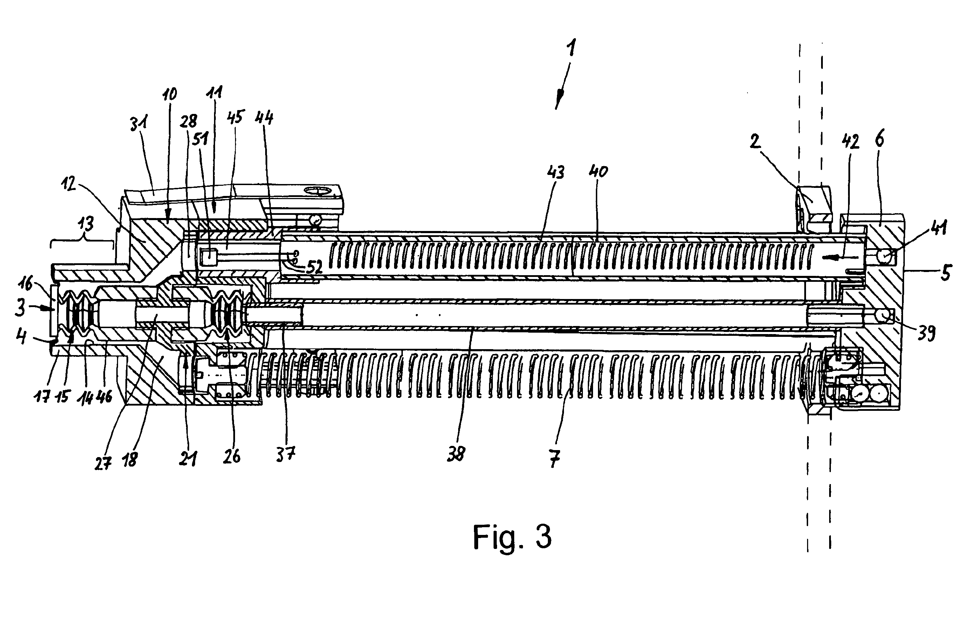

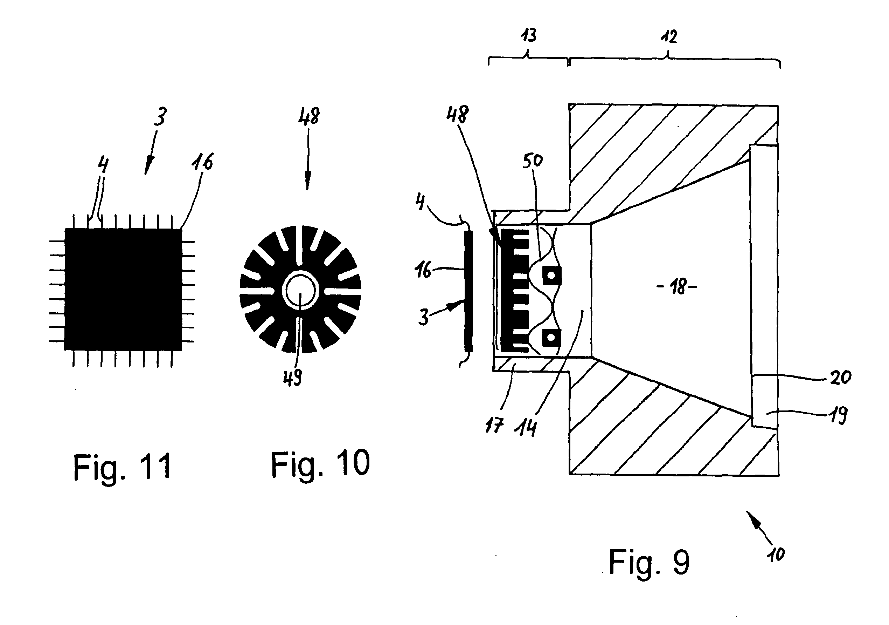

Aus den Figuren 1 bis 3 ist ein Plunger 1 ersichtlich, der längsverschiebbar an einer Plungerführungseinrichtung 2 geführt ist. Die Plungerführungseinrichtung 2 kann in einer nicht dargestellte Weise beispielsweise an einem Umlaufwagen oder an einer Schwenkeinrichtung befestigt sein, mit dem bzw. der der Plunger 1 zusammen mit einem auf dem Plunger 1 aufgesetzten, zu testenden elektronischen Bauelement 3 in eine Position gebracht werden können, in welcher der Plunger 1 geradlinig (in den Figuren 2 und 3 nach links) in eine Kontaktposition vorgeschoben werden kann, in der die Anschlussbeinchen 4 (Pins) des Bauelements 3 (s. Figur 11) auf entsprechende, nicht dargestellte Anschlusskontakte einer Kontakteinrichtung (Kontaktsockel) aufgesetzt sind. Bei dem Plunger 1 handelt es sich somit um eine Halteeinrichtung zum Halten eines Bauelements 3, die kolbenartig zwischen einer zurückgezogenen, in Figur 2 dargestellten Stellung und einer vorderen, in Figur 3 dargestellten Stellung hin- und herbewegt werden kann. Die Vorwärtsbewegung erfolgt dabei mittels einer nicht dargestellten Vorschubeinrichtung, welche auf eine hintere Stirnfläche 5 eines hinteren Endabschnitts 6 des Plungers 1 drückt. Das Zurückführen des Plungers 1 in seine Ausgangslage erfolgt über eine später noch näher beschriebene Rückholfeder 7, die mit ihrem hinteren Ende an der Plungerführungseinrichtung 2 befestigt ist.

Der Plunger 1 besteht aus einem vorderen Abschnitt 8, einem Zwischenabschnitt 9 und dem hinteren Endabschnitt 6.

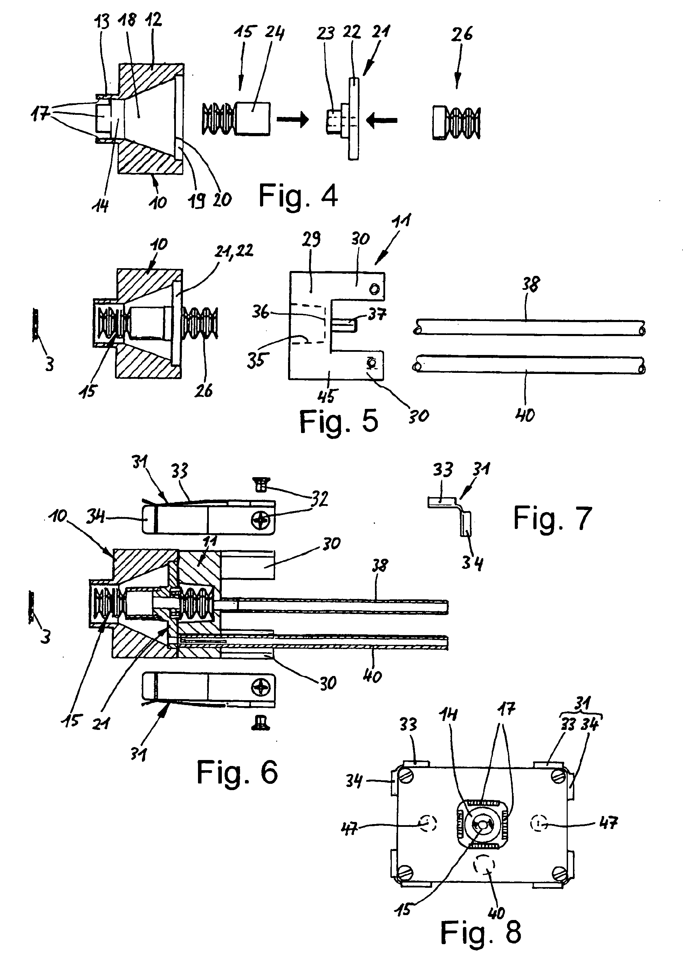

Der vordere Abschnitt 8 weist an seinem vorderen Ende ein Kopfteil 10 sowie daran axial anschließend einen Basiskörper 11 auf. Das Kopfteil 10 besteht aus einem quaderförmigen Kopfteilabschnitt 12, von dem aus ein im Durchmesser verringerter vorderer Kopfteilendabschnitt 13 in axialer Richtung vorsteht. Im Inneren weist das Kopfteil 10 eine zentrale, axiale Durchgangsöffnung 14 auf. In diese Durchgangsöffnung 14 kann von hinten her, d.h. in Figur 4 von rechts, ein Saugkopf 15 einer pneumatischen Halteeinrichtung eingeführt werden, mit der das Bauelement 3 festgesaugt werden kann.

Die Durchgangsöffnung 14 weist im Bereich des vorderen Kopfteilendabschnitts 13 einen Durchmesser auf, der größer ist als derjenige des Körpers 16 des Bauelements 3, so dass der Körper 16 mit radialem Abstand zu Beinchenstützstegen 17, welche das vordere Ende des Kopfteilendabschnitts 13 bilden, im Bereich der Durchgangsöffnung 14 plaziert werden kann. Die Anschlussbeinchen 4 des Bauelements 3 liegen dabei auf den Beinchenstützstegen 17 auf und gewährleisten dadurch eine definierte Position des Bauelements 3 relativ zum Kopfteil 10 des Plungers 1. Die Anordnung und Dimensionierung der Beinchenstützstege 17 hängt von der Art der zu testenden Bauelemente 3 ab. Im vorliegenden Ausführungsbeispiel sind vier ebene Beinchenstützstege 17 vorgesehen, welche, wie insbesondere aus Figur 8 ersichtlich, rechtwinklig zueinander angeordnet sind und die Durchgangsöffnung 14 von allen vier Seiten her einrahmen.

Im Bereich des quaderförmigen Kopfteilabschnitts 12 erweitert sich der Durchmesser der Durchgangsöffnung 14 nach hinten und bildet eine kegelförmige Fluidverteilkammer 18.

Im hinteren Endbereich des Kopfteils 10 ist eine Vertiefung 19 eingebracht, die mit der Umfangswand der Fluidverteilkammer 18 eine umlaufende Schulter 20 bildet. Die Fluidverteilkammer 18 ist derart dimensioniert, dass in ihr ein Saugschlauchverbinder 21 aufgenommen werden kann, wobei ein Flanschteil 22 des Saugschlauchverbinders 21 innerhalb der Vertiefung 19 liegt und an der Schulter 20 anliegt.

Der Saugschlauchverbinder 21 weist an seinem vorderen Ende einen mittigen, axial vorstehenden Rohrstutzen 23 auf, auf den ein Schlauchabschnitt 24 des Saugkopfs 15 aufgesteckt werden kann. Ein in den Figuren 2 und 3 dargestellter hinterer Rohrstutzen 25 des Saugschlauchverbinders 21 dient zum Aufstecken eines hinteren Schlauchbalgs 26. Die Rohrstutzen 23, 25 umgeben eine axial durchgehende Saugbohrung 27, die eine fluiddichte Verbindung zwischen dem Saugkopf 15 und dem hinteren Schlauchbalg 26 schafft.

Im Flanschteil 22 des Saugschlauchverbinders 21 ist weiterhin eine Axialbohrung 28 vorgesehen (Figuren 2, 3), durch die, wie nachstehend noch näher erläutert wird, temperiertes Fluid in die Fluidverteilkammer 18 eingeleitet werden kann.

Der Basiskörper 11 besteht, wie insbesondere aus den Figuren 1 und 5 ersichtlich, aus einem quaderförmigen Basisabschnitt 29 und vier Federbefestigungselementen 30. Die Federbefestigungselemente 30 sind jeweils in den Eckbereichen des Basisabschnitts 29 angeformt, haben eine L-förmigen Querschnitt und erstrecken sich vom Basisabschnitt 29 nach hinten über diesen hinaus. An den Federbefestigungselementen 30 können Federelemente 31, die in den Figuren 1 und 6 - 8 dargestellt sind, mittels Schrauben 32 festgeschraubt werden.

Jedes der vier Federelemente 31 weist zwei rechtwinklig zueinander angeordnete und miteinander verbundene Federzungen 33, 34 auf, die in Axialrichtung nach vorne über den Basiskörper 11 vorstehen, wie insbesondere aus Figur 1 ersichtlich ist. Wird das Kopfteil 10 auf den Basiskörper 11 aufgesetzt, liegen die Federzungen 33, 34 seitlich am quaderförmigen Kopfteilabschnitt 12 an und zentrieren dadurch das Kopfteil 10 in seitlicher Richtung relativ zum Basiskörper 11. Durch die Federwirkung der Federelemente 31 kann das Kopfteil 10 auf einfache Weise seitlich relativ zum Basiskörper 11 verschoben werden, wenn das Kopfteil 10 an einer nicht dargestellten Zentriereinrichtung vorbeigeführt wird, welche sich in unmittelbarer Nähe des Kontaktsockels befinden kann. Hierdurch wird verhindert, dass der gesamte Plunger 1 bei einem derartigen Zentriervorgang seitlich bewegt werden muss und dadurch unter Umständen verspannt wird.

Der Basiskörper 11 weist eine mittige Axialbohrung 35 (Figuren 1, 5) größeren Durchmessers auf, die zur Aufnahme des Schlauchbalgs 26 dient. Das hintere Ende des Schlauchbalgs 26 liegt dabei dicht an einer Wand 36 an, welche die Axialbohrung 35 nach hinten begrenzt. Über einen Rohrstutzen 37, der die Wand 36 durchdringt und der zum Aufstecken eines Saugschlauchs 38 dient, ist das Innere des Schlauchbalgs 26 mit dem Saugschlauch 38 verbunden.

Wie aus den Figuren 1 bis 3 ersichtlich, erstreckt sich der Saugschlauch 38 vom Basiskörper 11 bis zum hinteren Endabschnitt 6 und ist über einen im hinteren Endabschnitt 6 vorgesehenen Saugkanal 38 und eine nicht dargestellte, flexible Saugleitung mit einer nicht dargestellten Unterdruckerzeugungseinrichtung verbunden, die stationär beispielsweise innerhalb eines Handlers, d.h. eines Handhabungsautomaten für elektronische Bauelemente, angeordnet sein kann.

Aufgrund der beschriebenen Anordnung steht somit das Innere des Saugkopfs 15 mit der Unterdruckerzeugungseinrichtung in Fluidverbindung, so dass durch Erzeugen eines entsprechenden Unterdrucks das Bauelement 3 an der Vorderseite des Saugkopfs 10 festgesaugt und fest am Plunger 1 gehalten werden kann.

Der Plunger 1 verfügt über eine eigene Temperiereinrichtung, um das am Saugkopf 15 gehaltene Bauelement 3 mittels temperiertem Fluid auf eine bestimmte Temperatur zu bringen. Die Temperiereinrichtung wird anhand eines Ausführungsbeispiels beschrieben, bei dem das Fluid und damit das Bauelement 3 erwärmt werden. Es ist jedoch ebenfalls denkbar, am Plunger 1 eine Temperiereinrichtung zum Abkühlen des Bauelements 3 zu verwenden.

Die Temperiereinrichtung weist eine Fluidzufuhrleitung 40 auf, die über einen Fluidkanal 41, der sich im hinteren Endabschnitt 6 befindet, und eine nicht dargestellte flexible Fluidleitung mit einer Fluidversorgungseinrichtung verbunden ist. Mittels dieser Fluidversorgungseinrichtung wird Fluid, beispielsweise gereinigte Luft, die Umgebungstemperatur haben oder bereits vortemperiert sein kann, mit einem bestimmten Druck in die Fluidzufuhrleitung 40 eingeführt, wie mit dem Pfeil 42 veranschaulicht. Bei der Fluidzufuhrleitung 40 handelt es sich um ein Rohr, das sich vom hinteren Endabschnitt 6 des Plungers 1 bis zum vorderen Abschnitt 8 erstreckt und parallel zum Saugschlauch 38 angeordnet ist. Innerhalb der Fluidzuführleitung 40 befindet sich eine Heizeinrichtung 43, die im gezeigten Ausführungsbeispiel in der Form einer Heizspirale ausgebildet ist, die sich über den überwiegenden Teil der Länge der Fluidzuführleitung 40 erstreckt.

Die Fluidzuführleitung 40 ist an ihrem vorderen Ende an einer axial fluchtenden Anschlussbuchse 44 befestigt, die den quaderförmigen Basisabschnitt 29 des Basiskörpers 11 in axialer Richtung durchdringt und in diesem festgelegt ist. Das vordere Ende der Anschlussbuchse 44 liegt dabei dicht am Saugschlauchverbinder 21 an, dessen Axialbohrung 28 mit dem Kanal 45 der Anschlussbuchse 44 fluchtet. Da weiterhin die Axialbohrung 28 des Saugschlauchverbinders 21 in die Fluidverteilkammer 18 des Kopfteils 10 mündet, kann das über die Fluidzuführleitung 40 herangeführte Fluid, nachdem es mittels der Heizeinrichtung 43 auf die vorbestimmte Solltemperatur erwärmt worden ist, in der Fluidverteilkammer 18 gleichmäßig um den gesamten Saugkopf 15 herum geführt und im Ringraum 46 zwischen Saugkopf 15 und dem Kopfteilendabschnitt 13 zum Bauelement 3 geleitet werden. Das Bauelement 3 wird somit im Bereich um den Saugkopf 15 herum mit temperierten Fluid angeströmt und entsprechend temperiert.

Aus den Figuren 1 bis 3 ist weiterhin ein Temperatursensor 51 ersichtlich, der im vorderen Endbereich der Fluidzuführleitung 40 kurz vor der Fluidverteilkammer 18 angeordnet ist. Der Temperatursensor 51 ist Teil einer Regelvorrichtung, mit der die Leistung der Heizeinrichtung 43 in Abhängigkeit der vom Temperatursensor 51 gemessenen Ist-Temperatur geregelt werden kann. In den Figuren 2 und 3 sind elektrische Leitungen 52 dargestellt, mit denen der Temperatursensor 51 an die Regelvorrichtung angeschlossen ist. Diese Leitungen 52 sind in einem Bereich zwischen dem Temperatursensor 51 und der Heizeinrichtung 43 aus dem Heizrohr nach außen geführt, um ihre Beanspruchung und Beeinflussung durch die von der Heizeinrichtung 43 erzeugte Temperatur zu reduzieren.

Im Rahmen der Erfindung sind eine Vielzahl alternativer Temperiereinrichtungen denkbar. Beispielsweise ist es möglich, das Fluid nicht erst im Bereich des Plungers 1 zu temperieren, sondern ein bereits entsprechend temperiertes Fluid über den Plunger 1 zum Bauelement 3 zu leiten. Die anhand der Figuren dargestellte Temperiereinrichtung bietet jedoch den Vorteil, dass das Fluid in naher Nachbarschaft zum Bauelement 3 temperiert wird, so dass die Leistung der Temperiereinrichtung und damit die Fluidtemperatur in kürzester Zeit nachgeregelt werden kann, falls mittels (nicht dargestellter) Sensoren festgestellt wird, dass die Ist-Temperatur von der Soll-Temperatur abweicht.

Die Führung des Plungers 1 an der Plungerführungseinrichtung 2 erfolgt mittels zweier paralleler Führungsstangen 47, die lediglich aus Figur 1 ersichtlich sind. Die Führungsstangen 47 sind mit ihrem vorderen Ende am Basiskörper 11 und mit ihrem hinteren Ende am hinteren Endabschnitt 6 des Plungers 1 befestigt. Die Führungsstangen 47 sind in entsprechenden Führungsbuchsen, die in der Plungerführungseinrichtung 2 vorgesehen sind, längsverschiebbar geführt.

Wie bereits ausgeführt, erfolgt das Zurückbewegen des Plungers 1 aus der in Figur 3 gezeigten vorgeschobenen Kontaktposition in die in Figur 2 gezeigte zurückgezogene Ausgangsstellung mittels der Rückholfeder 7. Die Rückholfeder 7 ist mit ihrem hinteren Ende an der Plungerführungseinrichtung 2 und mit ihrem vorderen Ende am Basiskörper 11 befestigt. Es handelt sich bei der Rückholfeder 7 um eine Zugfeder, die beim Überführen des Plungers 1 von der Ausgangsstellung in die in Figur 3 gezeigte vorgeschobene Kontaktstellung gedehnt wird.

Zur Verbesserung der Wärmeübertragung vom temperierten Fluid auf das Bauelement 3 kann ein Wärmeleitkörper 48 vorgesehen sein, der in den Figuren 9 und 10 dargestellt ist. Der Wärmeleitkörper 48 besteht aus einem scheibenförmigen Körper mit einer Vielzahl von Vorsprüngen bzw. Lamellen, die nach hinten, d.h. gegen die Fluidströmungsrichtung, gerichtet sind. Weiterhin besteht der Wärmeleitkörper 48 aus einem gut wärmeleitenden Material. Auf seiner vorderen Stirnfläche, die mit dem Körper 16 des Bauelements 3 in Kontakt gelangt, ist der Wärmeleitkörper 48 eben ausgebildet, so dass eine größtmögliche Kontaktfläche zwischen Wärmeleitkörper 48 und Bauelement 3 geschaffen wird.

Der Außendurchmesser des Wärmeleitkörpers 48 ist nur geringfügig kleiner als der Durchmesser der Durchgangsöffnung 14 des Kopfteilendabschnitts 13 im Wesentlichen ausfüllt. Eine zentrale Bohrung 49 im Wärmeleitkörper 48 ermöglicht den Durchtritt des vorderen Endes des Saugkopfs 15, so dass der Wärmeleitkörper 48 um den Saugkopf 15 herum angeordnet werden kann, ohne diesen in seiner Funktion zu beeinträchtigen. Beim Ansaugen des Bauelements 3 durch den Saugkopf 15 wird das Bauelement 3 gegen den Wärmeleitkörper 48 gezogen, so dass es vollflächig auf diesem aufliegt.

Um zu gewährleisten, dass das Bauelement 3 auch dann eben auf dem Wärmeleitkörper 48 aufliegt, wenn die Anschlussbeinchen 4 des Bauelements 3 nicht die optimale Ausrichtung haben und ungleichmäßig auf den Beinchenstützstegen 17 aufliegen, ist der Wärmeleitkörper 48, wie in Figur 9 schematisch dargestellt, mittels einer Federeinrichtung 50 federnd in der Durchgangsöffnung 14 abgestützt. Diese Federeinrichtung 50 ist so ausgebildet, dass der Wärmeleitkörper 48 innerhalb der Durchgangsöffnung 14 in Schräglagen gebracht werden kann, um sich einer eventuellen Schräglage des Bauelementkörpers 16 anzupassen und dadurch einen innigen Kontakt zum Bauelementkörper 16 aufrecht zu erhalten.

## Patentansprüche

1. Plunger zum Halten und Bewegen von elektronischen Bauelementen, insbesondere von IC's zu bzw. von einer mit einer Testvorrichtung verbundenen Kontakteinrichtung, mit
- einem Kopfteil (10),
- einem im Kopfteil (10) angeordneten Saugkopf (15) zum Ansaugen eines Bauelements (3),
- einer Temperiereinrichtung zum Temperieren des am Saugkopf (15) gehalterten Bauelements (3) mittels eines Fluids,
**dadurch gekennzeichnet, dass** das Kopfteil (10) eine von temperiertem Fluid durchströmte Fluidverteilkammer (18) aufweist, in welcher der Saugkopf (15) angeordnet ist, so dass das temperierte Fluid den Saugkopf (15) umströmt und längs des Saugkopfs (15) zum Bauelement weitergeleitet wird.

2. Plunger nach Anspruch 1, **dadurch gekennzeichnet, dass** der Plunger (1) einen vorderen Abschnitt (8), einen hinteren Endabschnitt (6) und einen Zwischenabschnitt (9) aufweist, wobei die Temperiereinrichtung mindestens eine in den vorderen Abschnitt (8) mündende Fluidzuführleitung (40) aufweist und ein sich zwischen dem hinteren Endabschnitt (6) und dem vorderen Abschnitt (8) des Plungers (1) erstreckendes Heizrohr umfasst, in dem eine Heizeinrichtung (43) zum Erwärmen des Fluids vorgesehen ist.

3. Plunger nach Anspruch 2, **dadurch gekennzeichnet, dass** die Heizeinrichtung (43) aus einer elektrischen Widerstandsheizung in Form einer Heizspirale besteht, die sich zumindest über den größeren Teil der Länge des Zwischenabschnittes (9) erstreckt.

4. Plunger nach Anspruch 2 oder 3, **dadurch gekennzeichnet, dass** der vordere Abschnitt (8) des Plungers (1) einen am Zwischenabschnitt (9) befestigten Basiskörper (11) und das Kopfteil (10) umfasst, das am Basiskörper (11) festgelegt ist und eine die Fluidverteilkammer (18) umfassende, axiale Durchgangsöffnung (14) aufweist, durch die das temperierte Fluid zum Bauelement (3) geleitet wird.

5. Plunger nach Anspruch 4, **dadurch gekennzeichnet, dass** das Kopfteil (10) seitlich verschiebbar am Basiskörper (11) festgelegt ist und mittels Federelementen (31) in eine zentrierte Stellung relativ zum Basiskörper (11) gedrängt wird.

6. Plunger nach Anspruch 5, **dadurch gekennzeichnet, dass** die Federelemente (31) aus einer Mehrzahl von Federzungen (33, 34) bestehen, die am Basiskörper (11) befestigt sind und von gegenüberliegenden Seiten her das Kopfteil (10) übergreifen.

7. Plunger nach einem der Ansprüche 4 bis 6, **dadurch gekennzeichnet, dass** in einem vorderen Endbereich der axialen Durchgangsöffnung (14) ein aus einem gut wärmeleitfähigen Material bestehender Wärmeleitkörper (48) angeordnet ist, der eine große, vom temperierten Fluid angeströmte Oberfläche aufweist und derart angeordnet ist, dass das vom Saugkopf (15) festgesaugte Bauelement (3) in großflächigem Kontakt mit dem Wärmeleitkörper (48) ist.

8. Plunger nach Anspruch 7, **dadurch gekennzeichnet, dass** der Wärmeleitkörper (48) federnd innerhalb der Durchgangsöffnung (14) gehaltert ist, so dass die Lage des Wärmeleitkörper (48) an unterschiedliche Lagen des Bauelements (3) anpassbar ist.

9. Plunger nach einem der Ansprüche 2 bis 8, **dadurch gekennzeichnet, dass** im vorderen Endbereich der Fluidzuführleitung (40) ein Temperatursensor (51) angeordnet ist, der Teil einer Regelvorrichtung zum Regeln der von der Temperiereinrichtung erzeugten Temperatur ist.

## Claims

1. Plunger for holding and moving electronic components, in particular ICs, towards and away from a contacting means which is connected to a test device, comprising
- a head part (10)
- a suction head (15) arranged in the head part (10) for sucking in a component (3),
- a temperature control means for temperature-controlling the component (3) mounted on the suction head (15) by means of a fluid,
**characterised in that** the head part (10) comprises a fluid distribution chamber (18) through which temperature-controlled fluid flows and in which the suction head (15) is arranged, in such a way that the temperature-controlled fluid flows around the suction head (15) and is further guided along the suction head (15) to the component.

2. Plunger according to claim 1, **characterised in that** the plunger (1) comprises a front portion (8), a rear end portion (6) and an intermediate portion (9), the temperature control means comprising at least one fluid introduction line (40), which opens into the front portion (8), and a heating tube, which extends between the rear end portion (6) and the front portion (8) of the plunger (1) and in which a heating means (43) for heating the fluid is provided.

3. Plunger according to claim 2, **characterised in that** the heating means (43) consists of an electrical resistance heater in the form of a heating spiral, which extends at least over the majority of the length of the intermediate portion (9).

4. Plunger according to either claim 2 or claim 3, **characterised in that** the front potion (8) of the plunger (1) comprises a base body (11), which is fixed to the intermediate portion (9), and the head part (10), which is fixed to the base body (11) and comprises an axial through-opening (14) which comprises the fluid distribution chamber (18) and through which the temperature-controlled fluid is guided to the component (3).

5. Plunger according to claim 4, **characterised in that** the head part (10) is fixed laterally displaceably on the base body (11) and urged into a centred position relative to the base body (11) by spring members (31).

6. Plunger according to claim 5, **characterised in that** the spring members (31) consist of a plurality of spring tabs (33, 34), which are fixed to the base body (11) and overlap the head part (10) from opposite sides.

7. Plunger according to any one of claims 4 to 6, **characterised in that** a heat-conducting body (48) consisting of a highly thermally conductive material is arranged in a front end region of the axial through-opening (14), comprises a large surface over which the temperature-controlled fluid flows, and is arranged in such a way that the component (3) held by suction by the suction head (15) is in contact with the heat-conducting body (48) over a large area.

8. Plunger according to claim 7, **characterised in that** the heat-conducting body (48) is mounted resiliently inside the through-opening (14) in such a way that the position of the heat-conducting body (48) can be adapted to different positions of the component (3).

9. Plunger according to any one of claims 2 to 8, **characterised in that** a temperature sensor (51) is arranged in the front end region of the fluid supply line (40) and is part of an adjustment device for adjusting the temperature produced by the temperature control means.

## Revendications

1. Plongeur pour maintenir et déplacer des composants électroniques, en particulier des circuits intégrés vers ou depuis un dispositif de mise en contact relié à un dispositif de test, comprenant
- une partie de tête (10),
- une tête d'aspiration (15), agencée dans la partie de tête (10), pour aspirer un composant (3),
- un dispositif de températion pour tempérer le composant (3) maintenu sur la tête d'aspiration (15), au moyen d'un fluide,
**caractérisé en ce que** la partie de tête (10) comporte une chambre de répartition de fluide (18) traversée par le fluide tempéré, chambre dans laquelle est agencée la tête d'aspiration (15), de sorte que le fluide tempéré s'écoule tout autour de la tête d'aspiration (15) et est amené au composant le long de la tête d'aspiration (15).

2. Plongeur selon la revendication 1, **caractérisé en ce que** le plongeur (1) comprend un tronçon avant (8), un tronçon terminal arrière (6) et un tronçon intermédiaire (9), et le dispositif de températion comprend au moins une conduite d'amenée de fluide (40) qui débouche dans le tronçon avant (8) et englobe un tube chauffant s'étendant entre le tronçon terminal arrière (6) et le tronçon avant (8) du plongeur (1), et dans lequel il est prévu un moyen de chauffage (48) pour réchauffer le fluide.

3. Plongeur selon la revendication 2, **caractérisé en ce que** le moyen de chauffage (43) est un chauffage résistif sous la forme d'un serpentin chauffant, qui s'étend au moins sur la majeure partie de la longueur du tronçon intermédiaire (9).

4. Plongeur selon la revendication 2 ou 3, **caractérisé en ce que** le tronçon avant (8) du plongeur (1) comprend un corps de base (11) fixé sur le tronçon intermédiaire (9) et la partie de tête (10), laquelle est immobilisée sur le corps de base (11) et comporte une ouverture traversante axiale (14) qui englobe la chambre de répartition de fluide (18) et à travers laquelle le fluide tempéré est amené au composant (3).

5. Plongeur selon la revendication 4, **caractérisé en ce que** la partie de tête (10) est immobilisée latéralement et de façon déplaçable sur le corps de base (11) et est forcée au moyen d'éléments à ressort (31) vers une position centrée par rapport au corps de base (11).

6. Plongeur selon la revendication 5, **caractérisé en ce que** les éléments à ressort (31) sont constitués par une pluralité de languettes-ressorts (33, 34), qui sont fixées sur le corps de base (11) et qui coiffent la partie de tête (10) depuis des côtés opposés.

7. Plongeur selon l'une des revendications 4 à 6, **caractérisé en ce que** dans une région terminale avant de l'ouverture traversante axiale (14) est agencé un corps thermoconducteur (48), constitué en un matériau à bonnes qualités thermoconductrices, qui présente une surface importante le long de laquelle s'écoule le fluide tempéré, et agencé de telle façon que le composant (3) aspiré fermement par la tête d'aspiration (15) se trouve en contact à grande surface avec le corps thermoconducteur (48).

8. Plongeur selon la revendication 7, **caractérisé en ce que** le corps thermoconducteur (48) est maintenu avec effet élastique à l'intérieur de l'ouverture traversante (14), de sorte que la position du corps thermoconducteur (48) est susceptible de s'adapter à différentes positions du composant (3).

9. Plongeur selon l'une des revendications 2 à 4, **caractérisé en ce qu'**un capteur de température (51) et agencé dans la zone terminale de la conduite d'amenée de fluide (40), lequel fait partie d'un dispositif de régulation pour réguler la température engendrée par le dispositif de températion.
